(19) Europäisches Patentamt
European Patent Office
Office européen des brevets

(11) Veröffentlichungsnummer: **0 037 060**
**B1**

(12) # EUROPÄISCHE PATENTSCHRIFT

(45) Veröffentlichungstag der Patentschrift: **14.03.84**

(51) Int. Cl.³: **G 03 C 5/34** // B41N1/08, G03F7/08

(21) Anmeldenummer: **81102222.7**

(22) Anmeldetag: **25.03.81**

(54) **Verfahren und Entwicklerlösung zum Entwickeln von belichteten negativ arbeitenden Diazoniumsalzschichten.**

(30) Priorität: **31.03.80 DE 3012522**

(43) Veröffentlichungstag der Anmeldung: **07.10.81 Patentblatt 81/40**

(45) Bekanntmachung des Hinweises auf die Patenterteilung: **14.03.84 Patentblatt 84/11**

(84) Benannte Vertragsstaaten: **AT BE CH DE FR GB IT LI NL SE**

(56) Entgegenhaltungen:
**DE - B - 2 251 317**
**DE - B - 2 405 250**

(73) Patentinhaber: **HOECHST AKTIENGESELLSCHAFT, Postfach 80 03 20, D-6230 Frankfurt am Main 80 (DE)**

(72) Erfinder: **Schell, Loni, Dipl.-Chem., Erbacher Strasse 10, D-6238 Hofheim 4 (DE)**

**EP 0 037 060 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Verfahren und Entwicklerlösung zum Entwickeln von belichteten negativ arbeitenden Diazoniumsalzschichten

Die Erfindung betrifft eine Entwicklerlösung, die zum Entwickeln von negativ arbeitenden belichteten Kopiermaterialien auf Basis von Diazoniumsalz-Polykondensationsprodukten geeignet ist.

Kopiermaterialien der genannten Art werden vorzugsweise für die Herstellung von Druckplatten, aber auch von Photoresists verwendet und bestehen aus einem Schichtträger und einer negativ arbeitenden lichtempfindlichen Kopierschicht.

Als Schichtträger werden Metalle, wie Zink, Chrom, Kupfer, Messing, Stahl oder Aluminium, Kunststoffolien, Papier oder dgl., gegebenenfalls nach einer geeigneten Vorbehandlung, verwendet.

Als Kopierschichten werden solche auf Basis von wasserunlöslichen Diazoniumsalz-Polykondensationsprodukten und wasserunlöslichen Harzen als Bindemittel verwendet, insbesondere von Harzen, die auch in schwach sauren oder alkalischen wäßrigen Lösungen unlöslich sind.

Entwickler für belichtete Kopierschichten dieser Art erfordern normalerweise den Zusatz organischer Lösungsmittel. Auch dann wird aber in der Regel mit Entwicklern, die weniger als 50 Gew.-% organisches Lösungsmittel enthalten, keine echte Auflösung der unbelichteten Schichtbereiche, sondern lediglich eine Ablösung von dem Träger in mehr oder weniger großen filmartigen Fetzen (»Fladen«) bewirkt. Bei der Entwicklung mit der Hand kann man durch Anwendung eines genügenden Überschusses an Entwickler in der Regel zu einer sauber entwickelten Kopie kommen. Andererseits ist der Verbrauch an teurem, organisches Lösungsmittel enthaltendem Entwickler groß, und dessen Beseitigung bzw. Aufarbeitung bereitet zusätzliche Mühe und Kosten.

Insbesondere bei der Entwicklung von Hochleistungsdruckplatten der genannten Art haben sich Schwierigkeiten ergeben, wenn die Entwicklung in einem automatischen Durchlaufgerät erfolgen sollte, da sich hier nach relativ kurzer Zeit die im Entwickler dispergierte, unlösliche Schichtsubstanz im Gerät und womöglich auch auf zu entwickelnden Platten abschied und diese unbrauchbar machte.

Es wurden deshalb für die Entwicklung der genannten Typen von Reproduktionsschichten Entwickler mit höherem Gehalt (z. B. 50% oder mehr) an organischen Lösungsmitteln verwendet (DE-A-2 024 244, Beispiel 57). Auch bei diesem hohen Gehalt an organischem Lösungsmittel verbleibt bei Schichten, die große Mengen an wasserunlöslichen Bindemitteln enthalten, ein Rest an nicht gelöstem Schichtfeststoff im Entwickler dispergiert. Man hat zwar durch Zusatz von relativ großen Mengen an Netzmitteln zum Entwickler eine vollständige und stabile Dispersion und eine saubere Entwicklung erreichen können, doch ist es nicht möglich, Entwickler der in dem genannten Beispiel angegebenen Art in automatischen Entwicklungsvorrichtungen zu verarbeiten, weil diese Entwickler zu stark schäumen.

Für Schichten anderer Art wurden auch Entwicklerlösungen beschrieben, die wenig oder gar kein Wasser enthalten (DE-B-2 012 390). Auch diese Entwickler enthalten Netzmittel und sind in der Regel zum Entwickeln von Druckplatten der oben angegebenen Zusammensetzung zu aggressiv.

Schließlich sind aus der CA-A-1 057 105 auch Entwickler für Druckplatten der erfindungsgemäß zu behandelnden Art bekannt, die bis zu 95% an organischen Lösungsmitteln, z. B. Glykole oder Glykoläther, und Netzmittel enthalten, wobei unter diesen Komponenten auch Ethylenglykolester zu finden sind. Die Entwickler werden bei Temperaturen von 60—110°C angewendet (Seite 9, Zeilen 6—7 und 17—18). Bei diesen Temperaturen zeigen die Entwickler starke Neigung zum Schäumen, wenn sie in automatischen Verarbeitungsgeräten eingesetzt werden.

Aufgabe der Erfindung ist es, eine Entwicklerlösung für lichtempfindliche Schichten auf der Basis von wasserunlöslichen Diazoniumsalz-Polykondensationsprodukten und wasserunlöslichen Bindemitteln bereitzustellen, die eine vollständige Auflösung der nichtbelichteten Schichtbereiche gewährleistet und die zur Anwendung in automatischen Entwicklungsgeräten geeignet ist.

Die Erfindung geht aus von einer Entwicklerlösung zum Entwickeln von belichteten lichtempfindlichen Reproduktionsmaterialien, die ein wasserunlösliches Bindemittel und ein wasserunlösliches Diazoniumsalz-Polykondensationsprodukt enthalten, wobei die Lösung als wesentliche Bestandteile Glykoläther, Glykolester und Wasser enthält.

Die erfindungsgemäße Entwicklerlösung ist dadurch gekennzeichnet, daß sie

30—80% einer Verbindung der Formel

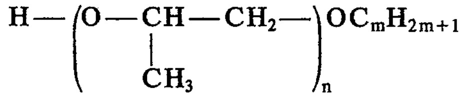

worin n = 1—4 und m = 1—5 bedeuten,

3—30% einer Verbindung der Formel

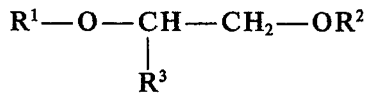

worin $R^1$ und $R^2$ Acylgruppen mit 1—4 C-Atomen oder einer von beiden Resten ein Wasserstoffatom und $R^3$ ein Wasserstoffatom oder eine Methylgruppe bedeuten,

0—15% 1,3-Dioxolan-2-on oder 4-Methyl-1,3-dioxolan-2-on,
0—20% eines mehrwertigen Alkohols,
0—10% eines organischen oder anorganischen in dem Lösungsmittelgemisch löslichen Salzes und
5—45% Wasser

enthält.

Die Prozentangaben sind als Gew.-% zu verstehen.

Reproduktionsmaterialien, die mit den erfindungsgemäßen Entwicklerlösungen entwickelt werden können, sind z. B. in der DE-A-2 024 244 = US-A-3 867 147 beschrieben.

Die erfindungsgemäßen Entwickler weisen eine hohe Standzeit in Entwicklungsmaschinen auf, da sie die beim Entwickeln entfernten Schichtbestandteile praktisch vollständig auflösen und da sie keine niedrigsiedenden Anteile enthalten. Bevorzugt haben die organischen Bestandteile des Entwicklers einen Siedepunkt oberhalb 100° C, insbesondere oberhalb 150° C.

Hauptbestandteil des erfindungsgemäßen Entwicklers ist eine Verbindung der Formel

$$H-\left(O-\underset{\displaystyle CH_3}{\underset{|}{CH}}-CH_2-\right)_n OC_mH_{2m+1}$$

worin die Symbole n und m die oben angegebene Bedeutung haben. Vorzugsweise hat n den Wert 1—3 und m den Wert 1—3, insbesondere 1. Die Menge des Glykoläthers beträgt im allgemeinen 30—80, vorzugsweise 45—60 Gew.-% der Lösung.

Als weiteren notwendigen Bestandteil enthält die Lösung einen Glykolester der Formel

$$R^1-O-\underset{\displaystyle R^3}{\underset{|}{CH}}-CH_2-OR^2$$

mit der oben angegebenen Bedeutung der Symbole $R^1$, $R^2$ und $R^3$.

Geeignete Beispiele sind Äthylenglykolmono- und -diacetat, -propionat oder Propandiolmonoacetat. Äthylenglykolmono- und -diacetat werden bevorzugt. Der Glykolester kann in einer Menge von 3—30, vorzugsweise 10—20 Gew.-% in der Lösung enthalten sein.

Als weitere Zusätze können Dioxolanderivate wie 1,3-Dioxolan-2-on und 4-Methyl-1,3-dioxolan-2-on in einer Menge bis 15, vorzugsweise bis 8 Gew.-%, enthalten sein.

Ferner sind höhere Alkohole und Glykoläther, z. B. Tetrahydrofurfurylalkohol, Benzylalkohol, 3-Methoxy-butanol, Diacetonalkohol, Diäthylenglykolmonoäthyläther, Äthylenglykolmonophenyläther und Diäthylenglykoldimethyläther als zusätzliche Lösungsmittel geeignet.

Auch können mehrwertige Alkohole mit Weichmacherwirkung, z. B. Glycerin, Äthylenglykol oder Propylenglykol in einer Menge von 0—20, vorzugsweise 3—15 Gew.-%, zugesetzt werden.

Die Entwicklerlösung kann weiterhin anorganische oder organische Salze, z. B. Ammoniumbenzoat oder Natriumtartrat, Lithiumnitrat, Strontiumnitrat oder Magnesiumsulfat in einer Menge von insgesamt 0—10 Gew.-% enthalten.

Der erfindungsgemäße Entwickler hat im allgemeinen einen pH-Wert von 2 bis 12, vorzugsweise von etwa 6 bis 8. Dabei wird der alkalische Bereich durch eines der oben angegebenen Salze und der saure Bereich vorzugsweise mit einer organischen Säure eingestellt.

Der erfindungsgemäße Entwickler enthält keine niedrigsiedenden Anteile. Normalerweise ist das Wasser, das in einer Menge von 5—45, vorzugsweise 15—28 Gew.-%, enthalten ist, der am niedrigsten siedende Bestandteil.

Der Entwickler ändert deshalb seine Zusammensetzung während des Gebrauchs nur unwesentlich und hat eine verhältnismäßig lange Standzeit in der Maschine.

Als besonderer Vorteil ist weiterhin anzusehen, daß der Entwickler keines Netzmittelzusatzes bedarf. Er ist bei Raumtemperatur voll wirksam, kann aber gegebenenfalls auch bei geringfügig, z. B. auf 40° C, erhöhter Temperatur angewendet werden, ohne daß er zu aggressiv wird. Bei den üblichen Gebrauchstemperaturen ist die Geruchsbelästigung gering.

Die folgenden Beispiele erläutern bevorzugte Ausführungsformen des erfindungsgemäßen Entwicklers. Prozentangaben und Mengenverhältnisse sind, wenn nichts anderes angegeben ist, in Gewichtseinheiten zu verstehen.

Beispiel 1

Eine durch Bürsten mit einer Schleifmittelsuspension aufgerauhte Aluminiumfolie wurde eine Minute in ein 60° C warmes Bad von 0,3% Polyvinylphosphonsäure in Wasser getaucht und getrocknet. Sie wurde dann mit einer Lösung von

0,7 Gt eines Polykondensationsproduktes, hergestellt aus 1 Mol 3-Methoxy-diphenylamin-4-diazoniumsulfat und 1 Mol 4,4'-Bis-methoxymethyl-diphenyläther in 85%iger Phosphorsäure, isoliert als Mesitylensulfonat,
3,4 Gt 85%iger Phosphorsäure und
3,0 Gt des Reaktionsproduktes aus einem Epoxidharz vom Schmelzpunkt 70° C und dem Epoxid-Äquivalentgewicht 459 mit Salzsäure in Äthylenglykolmonomethyläther (vgl. DE-A-2 034 654) in
60,0 Gt Äthylenglykolmonomethyläther,
20,0 Gt Tetrahydrofuran,
10,0 Gt Dimethylformamid und
10,0 Gt Butylacetat

beschichtet und getrocknet. Das lichtempfindliche Material wurde bildmäßig belichtet und mit einer Lösung von

60 Gt Propylenglykolmonomethyläther,
10 Gt Glycerin,
5 Gt Äthylenglykolacetat (Gemisch aus 50% Mono- und 50% Diacetat),
5 Gt Natriumbenzoat und
20 Gt Wasser

entwickelt.

Es wurde ein einwandfreies Bild erhalten.

Beispiel 2

Eine elektrolytisch aufgerauhte und anodisch oxydierte Aluminiumfolie, die wie in Beispiel 1 mit Polyvinylphosphonsäure nachbehandelt worden war, wurde mit einer Lösung von

1,6 Gt Polyvinylformal,
0,5 Gt eines Polykondensationsprodukts aus 1 Mol 3-Methoxy-diphenylamin-4-diazoniumsulfat und 1 Mol 4,4'-Bis-methoxymethyldiphenyläther, hergestellt in 85%iger Phosphorsäure bei 40° C und isoliert als Mesitylensulfonat,
0,05 Gt Phosphorsäure und
0,3 Gt ®Hostapermblau in
57 Gt Äthylenglykolmonomethyläther,
30 Gt Tetrahydrofuran und
8 Gt Butylacetat

beschichtet und getrocknet. Die erhaltene Flachdruckplatte wurde unter einer Vorlage belichtet und mit einer Lösung von

50 Gt Propylenglykolmonomethyläther,
15 Gt Äthylenglykolacetat (Gemisch aus Mono- und Diacetat 1 : 1),
0,5 Gt 1,3-Dioxolan-2-on,
1 Gt Ammoniumbenzoat,
10 Gt Glycerin und
23,5 Gt Wasser

entwickelt. Das Bild wurde sauber und fehlerfrei entwickelt, und es bildeten sich keine Fladen von ungelösten Schichtteilen.

**Patentansprüche**

1. Entwicklerlösung zum Entwickeln von belichteten lichtempfindlichen Reproduktionsschichten, die ein wasserunlösliches Bindemittel und ein wasserunlösliches Diazoniumsalz-Polykondensationsprodukt enthalten, wobei die Lösung als wesentliche Bestandteile Glykoläther, Glykolester und Wasser enthält, dadurch gekennzeichnet, daß sie

30—80% einer Verbindung der Formel

$$H-\left(O-\underset{\displaystyle CH_3}{\underset{|}{C}}H-CH_2-\right)_n OC_mH_{2m+1}$$

worin n = 1—4 und m = 1—5 bedeuten,

3—30% einer Verbindung der Formel

$$R^1-O-\underset{\displaystyle R^3}{\underset{|}{C}}H-CH_2-OR^2$$

worin $R^1$ und $R^2$ Acylgruppen mit 1—4 C-Atomen oder einer von beiden Resten ein Wasserstoffatom und $R^3$ ein Wasserstoffatom oder eine Methylgruppe bedeuten,

0—15% 1,3-Dioxolan-2-on oder 4-Methyl-1,3-dioxolan-2-on,
0—20% eines mehrwertigen Alkohols,
0—10% eines organischen oder anorganischen in dem Lösungsmittelgemisch löslichen Salzes und
5—45% Wasser

enthält.

2. Entwicklerlösung nach Anspruch 1, dadurch gekennzeichnet, daß sie ein pH zwischen 12 und 2 hat.

3. Entwicklerlösung nach Anspruch 1, dadurch gekennzeichnet, daß sie 0,5 bis 8% eines Alkali- oder Ammoniumsalzes einer organischen Säure enthält.

4. Verfahren zum Entwickeln von negativ arbeitenden Reproduktionsschichten auf Basis von wasserunlöslichen Diazoniumsalz-Polykondensationsprodukten und in Wasser und verdünnten wäßrigen Alkalien unlöslichen Bindemitteln, bei dem die belichtete Reproduktionsschicht mit einer Lösung aus Glykoläthern, Glykolestern, Wasser und ggf. mehrwertigen Alkoholen und Salzen zur Auflösung der unbelichteten Schichtbereiche behandelt wird, dadurch gekennzeichnet, daß man die Schicht mit einer Lösung behandelt, die

30—80% einer Verbindung der Formel

$$H-\left(O-\underset{\displaystyle CH_3}{\underset{|}{C}}H-CH_2-\right)_n OC_mH_{2m+1}$$

worin n = 1—4 und m = 1—5 bedeuten,

3—30% einer Verbindung der Formel

$$R^1-O-\underset{\displaystyle R^3}{\underset{|}{C}}H-CH_2-OR^2$$

worin $R^1$ und $R^2$ Acylgruppen mit 1—4 C-Atomen oder einer von beiden Resten ein Wasserstoffatom und $R^3$ ein Wasserstoffatom oder eine Methylgruppe bedeuten,

0—15% 1,3-Dioxolan-2-on oder 4-Methyl-1,3-dioxolan-2-on,
0—20% eines mehrwertigen Alkohols,
0—10% eines organischen oder anorganischen in dem Lösungsmittelgemisch löslichen Salzes und
5—45% Wasser

enthält.

## Claims

1. A developer solution for the development of exposed, light-sensitive reproduction layers which comprise a water-insoluble binder and a water-insoluble diazonium salt polycondensation product, the essential constituents of the solution being glycol ethers, glycol esters and water, characterized in that it contains

30 to 80% of a compound of the formula

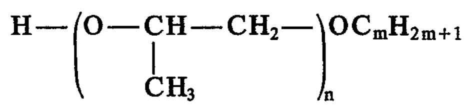

wherein n = 1 to 4 and m = 1 to 5,
3 to 30% of a compound of the formula

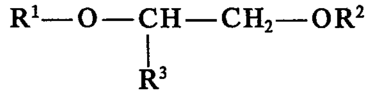

wherein $R^1$ and $R^2$ represent acyl groups containing 1 to 4 carbon atoms or one of the two groups represents a hydrogen atom and $R^3$ is a hydrogen atom or a methyl group,
0 to 15% of 1,3-dioxolane-2-one or 4-methyl-1,3-dioxolane-2-one,
0 to 20% of a polyhydric alcohol,
0 to 10% of an organic or inorganic salt which is soluble in the solvent mixture and
5 to 45% of water.

2. A developer solution as claimed in claim 1, which has a pH ranging between 12 and 2.

3. A developer solution as claimed in claim 1, which contains from 0.5 to 8% of an alkali salt or ammonium salt of an organic acid.

4. A process for the development of negative-working reproduction layers based on water-insoluble diazonium salt polycondensation products and binders which are insoluble in water and in dilute aqueous alkaline solutions, in which the exposed reproduction layer is treated with a solution composed of glycol ethers, glycol esters, water and optionally polyhydric alcohols and salts, in order to dissolve the unexposed layer areas, characterized in that the layer is treated with a solution of

30 to 80% of a compound of the formula

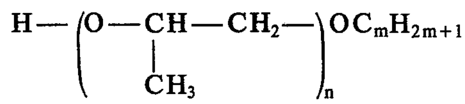

wherein n = 1 to 4 and m = 1 to 5,
3 to 30% of a compound of the formula

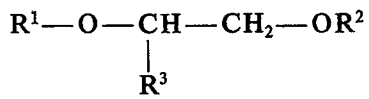

wherein $R^1$ and $R^2$ represent acyl groups containing 1 to 4 carbon atoms or one of the two groups represents a hydrogen atom and $R^3$ is a hydrogen atom or a methyl group,
0 to 15% of 1,3-dioxolane-2-one or 4-methyl-1,3-Dioxolane-2-one,
0 to 20% of a polyhydric alcohol,
0 to 10% of an organic or inorganic salt which is soluble in the solvent mixture and
5 to 45% of water.

## Revendications

1. Une solution de révélateur pour le développement de couches de reproduction sensibles à la lumière, exposées, qui comprenent un liant insoluble dans l'eau et un produit de polycondensation de sels de diazonium insoluble dans l'eau, les constituants principaux de la solution étant des éthers de glycol, des esters de glycol et de l'eau, caractérisée en ce qu'elle contient

30 à 80% d'un composé de formule

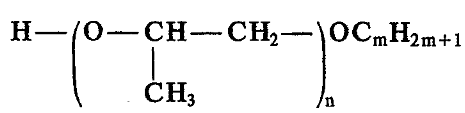

dans lequel n = 1 à 4 et m = 1 à 5,
3 à 30% d'un composé de formule

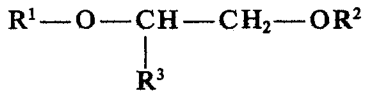

dans lequel $R^1$ et $R^2$ représentent des groupes acyle contenant de 1 à 4 atomes de carbone ou un des deux groupes représente un atome d'hydrogène et $R^3$ est un atome d'hydrogène ou un groupe méthyle,

0 à 15% de 1,3-dioxolane-2-one ou de 4-méthyl-1,3-dioxolane-2-one,

0 à 20% d'un polyol,

0 à 10% d'un sel organique ou inorganique qui est soluble dans le mélange de solvants et

5 à 45% d'eau.

2. Une solution de révélateur selon la revendication 1, qui a un pH compris entre 12 et 2.

3. Une solution de révélateur selon la revendication 1, qui contient de 0,5 à 8% d'un sel alcalin ou d'un sel d'ammonium d'un acide organique.

4. Procédé pour le développement de couches de reproduction fonctionnant en négatif, basées sur des produits de polycondensation de sels de diazonium insolubles dans l'eau et sur des liants qui sont insolubles dans l'eau et dans des solutions alcalines aqueuses diluées, dans lequel la couche de reproduction exposée est traitée avec une solution composée d'éthers de glycol, d'esters de glycol, d'eau et éventuellement de polyols et de sels, pour dissoudre les zones non exposées de la couche, caractérisé en ce que la couche est traitée avec une solution de

30 à 80% d'un composé de formule

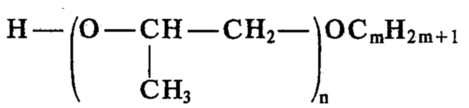

dans lequel n = 1 à 4 et m = 1 à 5,

3 à 30% d'un composé de formule

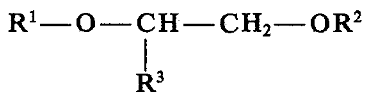

dans lequel $R^1$ et $R^2$ représentent des groupes acyle contenant de 1 à 4 atomes de carbone ou un des deux groupes représente un atome d'hydrogène et $R^3$ est un atome d'hydrogène ou un groupe méthyle,

0 à 15% de 1,3-dioxolane-2-one ou de 4-méthyl-1,3-dioxolane-2-one,

0 à 20% d'un polyol,

0 à 10% d'un sel organique ou inorganique qui est soluble dans le mélange de solvants et

5 à 45% d'eau.